# EUROPEAN PATENT SPECIFICATION

(11) **EP 2 251 906 B1**
(45) Date of publication and mention of the grant of the patent: **26.07.2017**
(21) Application number: 09015492.3
(22) Date of filing: 15.12.2009
(51) Int. Cl.: H01L 27/32, H01L 51/00, H01L 51/56, H05B 33/10

(54) **Method of fabricating organic light emitting diode display**
Verfahren zur Herstellung einer OLED-Anzeige
Procédé de fabrication d'affichage à diode électroluminescente organique

(30) Priority: 12.05.2009 KR 20090041245
(43) Date of publication of application: 17.11.2010
(73) Proprietor: LG Display Co., Ltd., Seoul, 07336 (KR)
(72) Inventor: Kim, Woochan, Seoul (KR); Ahn, Byungchul, Seoul (KR); Han, Changwook, Seoul (KR)
(74) Representative: Ter Meer Steinmeister & Partner

(56) References cited:
- EP-A2- 0 883 190
- JP-A- 2001 295 027
- KR-B1- 100 685 410
- US-A1- 2003 148 021
- US-A1- 2003 230 238
- US-A1- 2006 141 135
- US-A1- 2008 224 607
- US-A1- 2008 268 135
- US-A1- 2009 038 550

## Description

### BACKGROUND

### Field

This document relates to a method of fabricating an organic light emitting diode display.

### Related Art

Recently, various flat panel display devices are being developed to reduce weight and volume, the shortcomings of the existing cathode ray tubes (CRTs). Such a flat panel display device includes a liquid crystal display (LCD), a field emission display (FED), a plasma display panel (PDP), an electroluminescence (EL) device, and the like.

The PDP receives much attention as a display device because its fabrication process is simple and it is so light, thin, short, and small as to be most favored to secure a large scale screen, but has shortcomings in that its luminous efficiency and luminance are low and it consumes much power. A thin film transistor (TFT) LCD is one of the most commonly used flat panel display devices, but with a problem in that its viewing angle is narrow and response speed is low. The EL device is divided into an inorganic light emitting diode display device and an organic light emitting diode display device according to a material of a light emission layer. Among them, the organic light emitting diode display device, a self-emission device, has advantages of fast response speed and high luminous efficiency and luminance, and a wide viewing angle.

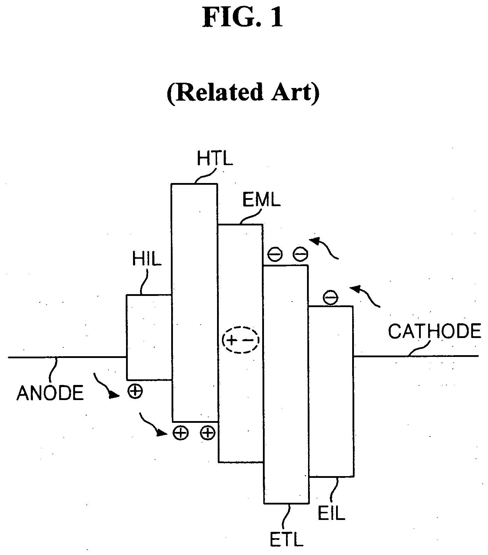

The organic light emitting diode display device has an organic light emitting diode (OLED) as shown in FIG. 1.

The OLED includes an organic compound layer, and cathode and anode electrodes facing each other with the organic compound layer interposed therebetween. The organic compound layer is formed as a multi-layer by stacking an electron injection layer (EIL), an electron transport layer (ETL), an emission layer (EML), a hole transport layer (HTL), and a hole injection layer (HIL). When a driving voltage is applied to the anode and cathode electrodes, holes which have passed through the HTL and electrons which have passed through the ETL are moved to the EML to form excitons to resultantly make the EML emit visible light.

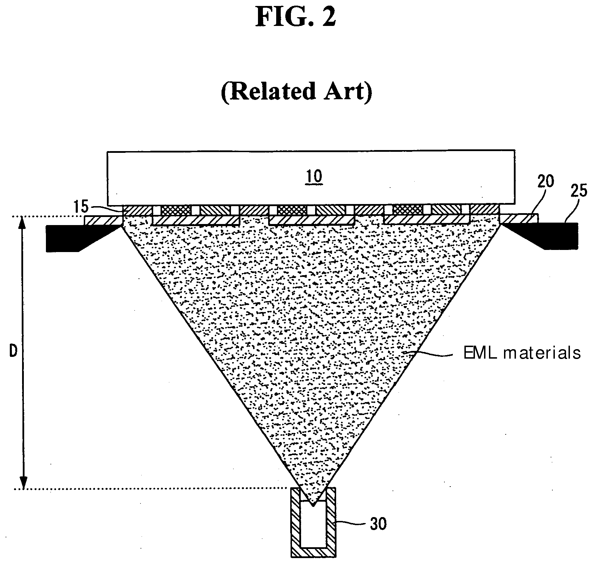

In the related art OLED display device, the EML is formed through a thermal evaporation method as shown in FIG. 2. To perform the thermal evaporation method, a boat 30 that houses EML materials for R, G, and B, and a metal mask 20 for inducing the EML materials transferred from the resistance-heated boat 30 such that they are deposited at a corresponding position are required, the metal mask 20, supported by a mask frame 25, is aligned on a substrate 10 with a thin film transistor (TFT) array 15 formed thereon. In the related art OLED display device, the R, G, and B EMLs are deposited by changing the alignment position of the metal mask 20.

Such related art OLED display device fabrication method has the following problems.

First, in the related art method, the size of the metal mask is determined according to the size of a substrate. As the substrate is increased in size, the size of the metal mask is bound to be increased. As the size of the metal mask increases, the mask is increasingly bent. Thus, in the related art deposition method using the metal mask, it is difficult to precisely pattern a light emission layer, failing to cope with a large area and high definition.

Second, in the related art method, the boat holding the light emission materials is separated by a certain distance from a substrate and heated, and then, the light emission materials are deposited on the substrate, which results in lengthening of a process total accumulated time (TACT) in forming a light emission layer. As the substrate is increased in size, the distance (D) between the substrate and the boat is bound to be increased to secure uniformity of the light emission layer deposited on the substrate, leading to an increase in the size of a chamber used for forming the light emission layer.

US 2006/0141135 describes processes for forming layers for electronic devices using heating elements. Herein, a micro-heater array includes a base material, heating elements, a protective layer, and a deposition source. The deposition source can be used to deposit a variety of different materials including a radiation-emitting organic active layer. The micro-heater array is aligned to a substrate that may be used in forming a passive matrix display for an electronic device. A first electrode overlies the substrate. Although not shown, the first electrode is one of a set of first electrodes that are orientated in substantially parallel strips that have a length extending from side to side. Substrate structures are formed over the substrate and first electrodes. The substrate structures are cathode separators, as conventionally used within passive matrix displays within the organic electronic arts. The substrate structures can also be well structures which have a similar or different shape compared to the substrate structures. The substrate structures are narrower near the substrate as supposed to a point further from the substrate. The substrate structures can be made of an inorganic material like silicon dioxide or silicon nitride or an organic material and are formed using conventional deposition and lithographic techniques.

US 2009/0038550 describes an evaporation source, a manufacturing method of the same and a manufacturing method of an organic EL display device. Herein, a glass substrate is aligned with an element-forming substrate for transferring an evaporating material layer formed on the glass substrate. The glass substrate has a plurality of first electrode patterns formed along a first direction in a striped manner on one of its sides. Further, the glass substrate has a plurality of second electrode patterns formed thereon such that the same patterns intersect with the first electrode patterns. The second electrode patterns are formed with a given spacing therebetween along a second direction being perpendicular to the first direction in a striped manner. Resistance heating layers are sandwiched at each of the intersecting sections between the first and second electrode patterns. On these electrode structures, an evaporating material layer comprising an organic light-emitting material is formed over the glass substrate. An element-forming substrate receiving sublimated evaporating material from the evaporating material layer has a pixel defining film formed thereon, wherein the organic light-emitting material is deposited only onto unit pixel portions which are opposed to the intersecting portions between the first electrode patterns and the second electrode patterns. US 2008/0224607 A1 describes a display. In a manufacturing method of the display, a donor substrate, on which a transfer layer containing a light-emitting material has been formed, is brought uniformly into tight contact with an acceptor substrate. On the acceptor substrate, a first electrode and an insulating layer have been formed. After alignment of the donor substrate and the acceptor substrate, irradiation with laser light is carried out to sublime or evaporate the transfer layer to thereby transfer the transfer layer at least onto a light-emission area of the acceptor substrate. Thereby, a light-emitting layer is formed. A rib may be provided on the top surface of the insulating layer. The rib may extend along both the longitudinal direction and the width direction of the light-emission area. Alternatively, it may extend only along the longitudinal direction of the light-emission area. More alternatively, it may be provided in a dotted manner. The rib can be formed by carrying out double exposure in a photolithography step for processing the insulating layer. Furthermore, the rib may be provided at both ends of the top surface of each portion of the insulating layer. Alternatively, the insulating layer on both sides of the light-emission area may be shaped differently from each other.

US 2008/0268135 A1 discloses a manufacturing method of a light-emitting device. Accordingly, a layer including an organic compound is selectively formed with a light-exposure apparatus used in a photolithography technique without a resist mask. A material layer including a photopolymerization initiator, a composition that reacts with the photopolymerization initiator under the influence of light to form a polymerized material, and an organic compound are formed on a plate, and then are exposed to light and selectively cured. A film-formation substrate is disposed so as to face the plate. The film-formation substrate or the material layer is heated so that the organic compound included in a region exposed to light or a region not exposed to light is evaporated to be selectively deposited on the surface of the film-formation substrate.

EP 0 883 190 A2 discloses a method of forming high definition patterned organic layers in a full-color electroluminescent (EL) display array on a two-dimensional thin film transistor (TFT) array substrate. The substrate has subpixels with each subpixel having raised surface portions and one recessed surface portion which reveals a bottom electrode. Red, green, and blue color forming organic EL layers are formed in the designated subpixels in accordance with a selected color pattern. The method uses a donor support which is coated with a transferable coating of an organic EL material. The donor support is heated to cause the transfer of the organic EL material onto the designated recessed surface portions of the substrate forming the colored EL medium in the designated subpixels. Optical masks and, alternatively, an aperture mask are used to selectively vapor deposit respective red, green, and blue organic EL media into the designated color EL subpixels.

### SUMMARY

It is an object of the present invention to provide a method of fabricating an organic light emitting diode display device capable of precisely and clearly patterning a light emission layer to support a larger area and high definition.

According to the present invention, a method of fabricating an organic light emitting diode display device is provided, which is capable of reducing a process TACT in forming a light emission layer and the size of a chamber for forming the light emission layer.

The above-mentioned object is solved by a method according to claim 1. Further advantages, refinements and embodiments of the invention are described in the respective sub-claims.

The metal pattern may be made of one or an alloy of two or more of Ag, Au, Al, Cu, Mo, Pt, Ti, W, and Ta.

The step of forming the light emission layer may be performed under a vacuum or an inert gas atmosphere.

The power voltage may be applied one or several times with a power density of 0.1 W/cm² ~ 10000 W/cm² within one second.

The method of fabricating an organic light emitting diode display device may further include: forming an electric insulation layer on the metal pattern before the organic light emission material layer is formed.

The electric insulation layer may include at least one of a silicon oxide film, a silicon nitride film, a silicon oxynitride film, and a spin-on-glass (SOG) material.

The spacers may be formed as one of a line, column, and well type spacers.

### BRIEF DESCRIPTION OF THE DRAWINGS

The accompanying drawings, which are included to provide a further understanding of the invention and which are incorporated in and constitute a part of this specification, illustrate embodiments of the invention and together with the description serve to explain the principles of the invention.

In the drawings:
FIG. 1 illustrates the structure of an organic light emitting diode.
FIG. 2 illustrates formation of an emission layer through the related art boat method using a metal mask.
FIG. 3 is a flow chart illustrating the process of a method of fabricating an organic light emitting diode (OLED) display device according to an exemplary embodiment of the present invention.
FIGs. 4a to 4d are sequential sectional views showing the process of forming a thin film transistor (TFT) array, and a first electrode, a bank pattern, and a hole relevant layer of an OLED on an acceptor substrate.
FIGs. 5a and 5b are sequential sectional views showing the process of forming a metal pattern and an organic light emission material layer on a donor substrate.
FIGs. 6a and 6b are sequential sectional views showing the process of forming a light emission layer through attachment and transferring.
FIGs. 7a and 7b are sequential sectional views showing the process of forming an electron relevant layer and a second electrode of the OLED.
FIGs. 8a and 8b are equivalent circuits of a pixel.
FIG. 9 illustrates the width of a metal pattern compared with a pixel width and a bank pattern width.
FIG. 10 is a process sectional view showing further inclusion of a spacer.
FIG. 11 is a process sectional view showing further inclusion of an electric insulation layer.

### DETAILED DESCRIPTION

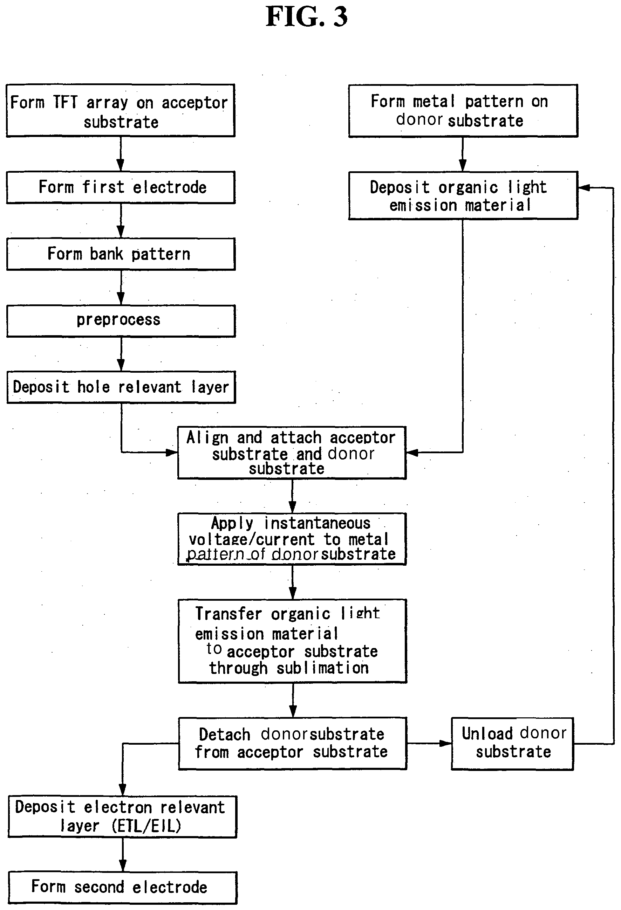

Exemplary embodiments of the present invention will now be described with reference to FIGs. 3 to 11.

With reference to FIG. 3, according to a method of fabricating an organic light emitting diode (OLED) display device according to an exemplary embodiment of the present invention, an acceptor substrate with a thin film transistor (TFT) array, a first electrode of an OLED, a bank pattern, and a hole relevant layer formed thereon and a donor substrate with a metal pattern and an organic light emission material layer formed thereon are aligned and attached under an inert gas atmosphere. Subsequently, an instantaneous voltage/current is applied to the metal pattern of the donor substrate to generate Joule heat to sublimate the organic light emission material formed on the donor substrate so as to be transferred to the acceptor substrate. Such attaching and transferring process is performed simultaneously on R, G, and B pixels one time, respectively, while attaching/detaching and unloading the donor substrate. After the light emission layers are formed on all of the R, G, and B pixels, an electron relevant layer and a second electrode of the OLED are sequentially deposited on the acceptor substrate with the R, G, and B light emission layers formed thereon.

The process of forming the TFT array, the first electrode of the OLED, the bank pattern, and the hole relevant layer on the acceptor substrate, and the process of forming the metal pattern and the organic light emission material layer on the donor substrate will now be described.

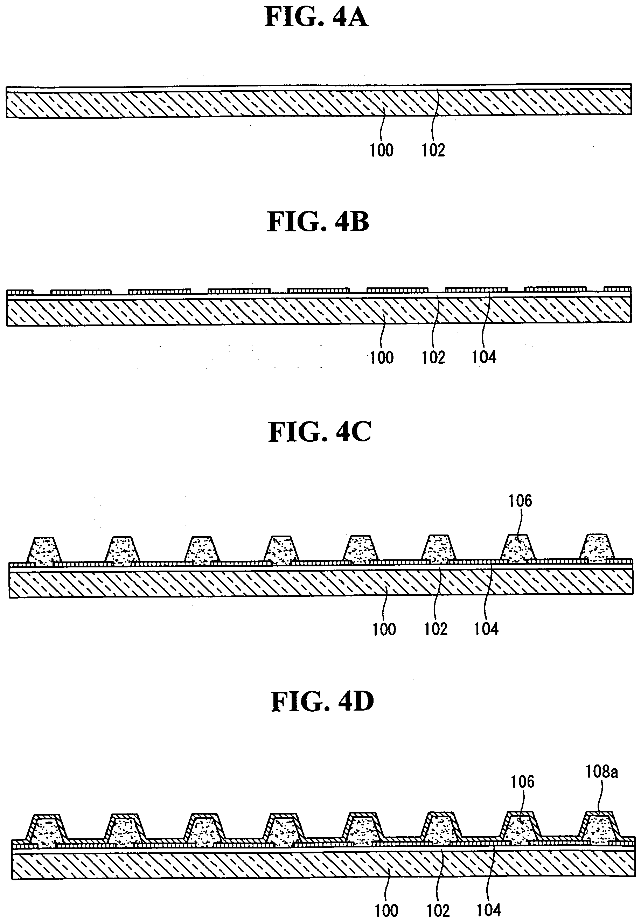

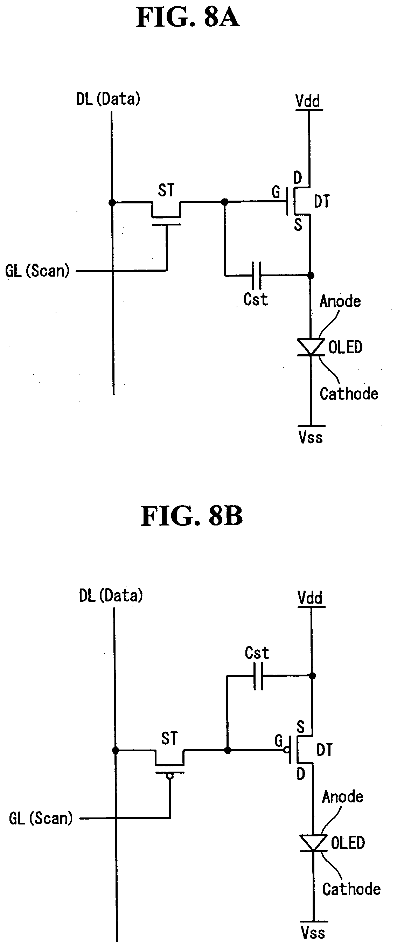

With reference to FIG. 4a, the TFT array 102 including a gate line GL, a data line DL, a switch TFT (ST), a driving TFT (DT), a storage capacitor Cst, a Vdd supply wiring, a Vss supply wiring, and the like, as shown in FIGs. 8a and 8b is formed on the acceptor substrate 100 made of transparent glass or a plastic material. The TFTs (ST and DT) may be implemented as N type MOSFETs as shown in FIG. 8a, or may be implemented as P type MOSFETs as shown in FIG. 8b. An equivalent circuit of a pixel illustrated in FIGs. 8a and 8b is an example of a general 2T1C structure, and the TFT array structure of the present invention is not limited thereto. The TFT array 102 may include a passivation layer for protecting the TFT array against an external environment, an overcoat layer for preventing generation of a step due to the TFTs (ST and DT), and a buffer layer for shielding outgassing from the overcoat layer.

With reference to FIG. 4b, the first electrode 104 of the OLED is formed on the acceptor substrate 100 with the TFT-array 102 formed thereon. The first electrode 104 comes in contact with one electrode of the driving TFT (DT) through the buffer layer, the overcoat layer, the passivation layer, and the like. The first electrode 104 is an anode electrode having a reflection film according to a connection structure with the driving TFT (DT). In other words, in FIG. 8a, the first electrode 104 is an anode electrode connected with a source electrode (S) of the driving TFT (DT), and in FIG. 8b, the first electrode 104 is an anode electrode connected with a drain electrode (D) of the driving TFT (DT). The first electrode 104 is a transparent conductor containing an oxide such as indium tin oxide (ITO) or indium zinc oxide (IZO), which is patterned by pixels on the reflection film made of an opaque metal material. The first electrode 104 applies holes, which are supplied by way of the driving TFT (DT), to an organic compound layer.

With reference to FIG. 4c, the bank patterns 106 is formed on the acceptor substrate 100 with the first electrode 104 formed thereon. The bank pattern 106 is formed at boundary regions between pixels, partitioning opening regions of respective pixels. After the bank pattern 106 is formed on the acceptor substrate 100, pre-processing is performed using plasma. The pre-processing is performed to remove debris remaining on the acceptor substrate 100 before the organic compound layer of the OLED is formed.

With reference to FIG. 4d, a hole injection layer (HIL) material and a hole transport layer (HTL) material are successively deposited on the entire surface of the acceptor substrate 100 with the bank pattern 106 formed thereon through a thermal evaporation process using an existing boat or the like to form the hole relevant layer 108a.

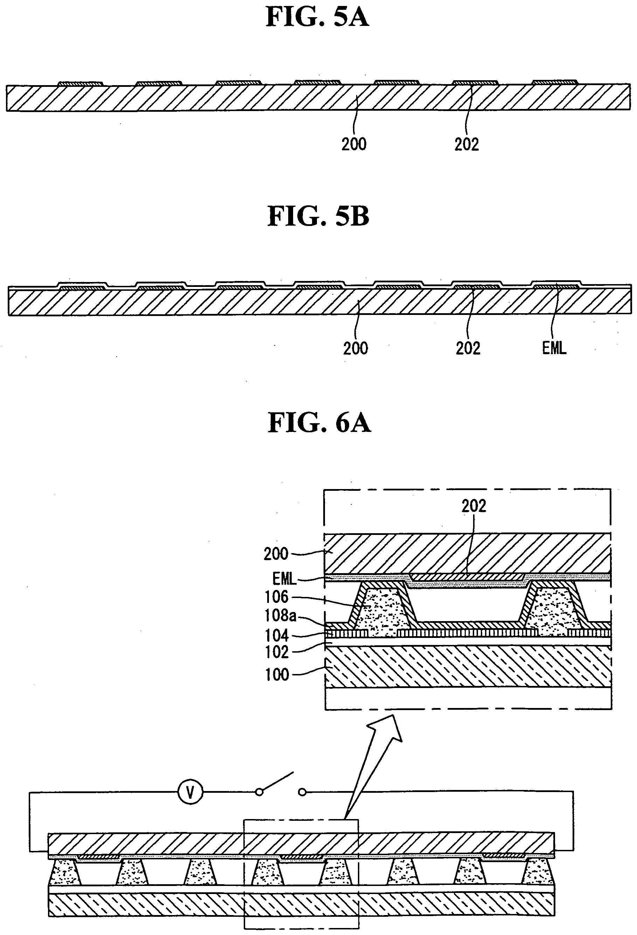

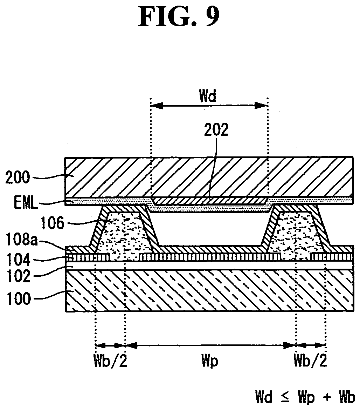

With reference to FIG. 5a, the metal pattern 202 is formed on the donor substrate 200 made of transparent glass or a plastic material. The size of the donor substrate 200 may be equal to or larger than the size of the acceptor substrate 100. The metal pattern 202 may include at least one or two or more of Ag, Au, Al, Cu, Mo, Pt, Ti, W, and Ta, or an alloy material. The metal pattern 202 may be obtained by depositing the metal or alloy on the entire surface of the donor substrate 200 by using one of a chemical vapor deposition process, a sputtering process, an e-beam process, and an electrolysis/electroless plating process, and then patterning the deposited metal or alloy through a photolithography process, a wet etching process, or a dry etching process. The metal pattern 202 is formed to correspond to pixel positions of the acceptor substrate 100 to which the organic light emission material is to be transferred. As shown in FIG. 9, the width Wd of the metal pattern 202 may be equal to or smaller than a value obtained by adding the width Wb of the bank pattern 106 partitioning neighboring pixels to a width Wp of each R, G, and B pixel of the acceptor substrate 100. The thickness of the metal pattern 202 may be within a maximum 1µm in consideration of a resistance component that generates Joule heat.

With reference to FIG. 5b, the organic light emission material layer (EML) is deposited on the entire surface of the donor substrate 200 with the metal pattern 202 formed thereon through a thermal evaporation process using the existing boat or the like.

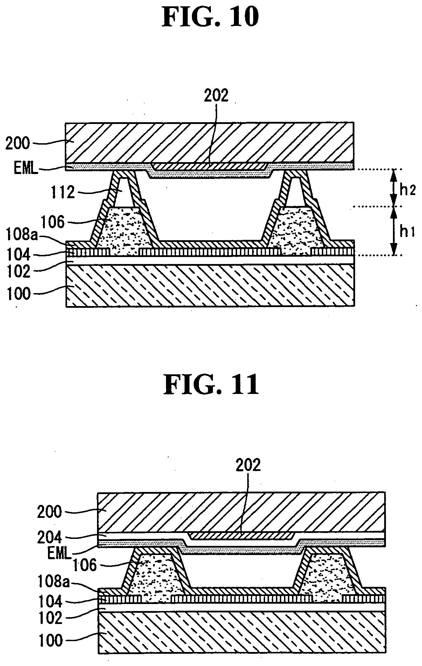

In order to prevent the metal pattern 202, which generates Joule heat, from being oxidized or spreading to the organic light emission material layer (EML) to be transferred, in the present invention, an electric insulation layer 204 may be formed between the metal pattern 202 and the organic light emission material layer (EML), as shown in FIG. 11. Here, the electric insulation layer 204 may be selected from among a silicon oxide film, a silicon nitride film, and a silicon oxynitride film and deposited on the entire surface of the metal pattern 202 through a CVD process or a sputtering process. In addition, as the electric insulation layer 204, a material such as spin-on-glass (SOG) may be selected to be deposited on the entire surface of the metal pattern 202 through a thermal process after spin-coating is performed thereon.

Next, the process of forming the organic light emission material layer through attachment and transferring will be described.

With reference to FIG. 6a, the acceptor substrate 100 with the hole relevant layer 108a formed thereon and the donor substrate 200 with the organic light emission material layer (EML) formed thereon are aligned and attached. The aligning and attaching process is performed under vacuum or inert gas (Ar, N₂, etc.) atmosphere to protect the organic light emission material layer (EML) against moisture/oxygen. The attachment may be performed through mechanical pressing.

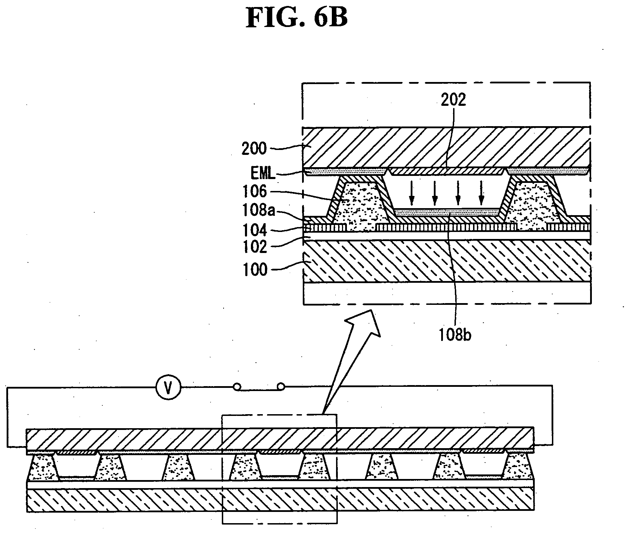

With reference to FIG. 6b, power voltage (V) is applied from the exterior to the metal pattern of the donor substrate 200 for which the aligning and attaching process has been completed. The power voltage (V) application causes the metal pattern 202 to generate Joule heat to sublimate the upper organic light emission material layer (EML). As a result, the organic light emission material layer (EML) is transferred to a corresponding region of the acceptor substrate 100 to form a light emission layer 108b. Here, because the acceptor substrate 100 and the donor substrate 200 are substantially tightly attached with the bank pattern 106 interposed therebetween, a color mixing phenomenon that may be otherwise generated as the transfer position of the organic light emission material layer (EML) is misaligned or spreads can be prevented in the exemplary embodiment of the present invention. In other words, in the exemplary embodiment of the present invention, the existing boat method using a metal mask is not used in forming the light emission layer 108b, so that the light emission layer 108b can be precisely patterned to fit to an increase in size of a substrate, properly coping with the trend of a large substrate and high definition.

If the organic light emission material layer (EML) is exposed to high temperature for a long time, the material may be altered or its chemical bonding may be broken. Thus, in order to prevent the organic light emission material layer (EML) from being thermally altered, a time duration for applying power to the metal pattern 202 is preferably, within the range of 0.1µs to Is, and the density of power applied to the metal pattern 202 is preferably within 0.1 W/cm² to 10000 W/cm². Power applied to metal pattern 202 may be AC power or DC power, and may be intermittently applied several times. According to an exemplary embodiment of the present invention, a process time required for forming the light emission layer 108b can be significantly reduced compared with the existing boat method using a metal mask, increasing throughput.

In an exemplary embodiment of the present invention, as shown in FIG. 10, spacers 112 are formed to be narrower than the bank pattern 106 between the bank pattern 106 and the hole relevant layer 108a. The spacers 112 may be formed in a line or column type on the bank pattern 106, or may be formed in a well type. The spacers 112 increase the partitioning height between pixels to prevent the organic light emission material layer (EML) from being deposited at a neighboring pixel in a different color, thus effectively preventing generation of a color mixing phenomenon or the like. In addition, the spacers 112 reduce a contact area between the acceptor substrate 100 and the donor substrate 200 in forming the light emission layer 108b, to facilitate attaching and detaching of the acceptor and donor substrates 100 and 200, resulting in a considerable reduction in the possibility of generation of debris in attaching or detaching the acceptor and donor substrates 100 and 200. In the case of forming the spacers 112, a deposition distance of the organic light emission material layer (EML) by Joule heat is determined by a height h1 of the bank pattern 106 and a height h2 of the spacers 112. In spite of the formation of the spacers, the deposition distance of the organic light emission material layer (EML) is remarkably reduced compared with that in the existing boat method, so that the size of a chamber for forming the light emission layer 108b can be drastically reduced.

Such attaching and transferring process is simultaneously performed on the R, G, and B pixels one time, respectively, while attaching/detaching and unloading the donor substrate 200. After the organic light emission material layer (EML) is transferred to all the R, G, and B pixels, the attaching and transferring process is finished.

The process of forming the electron relevant layer and the second electrode of the OLED will now be described.

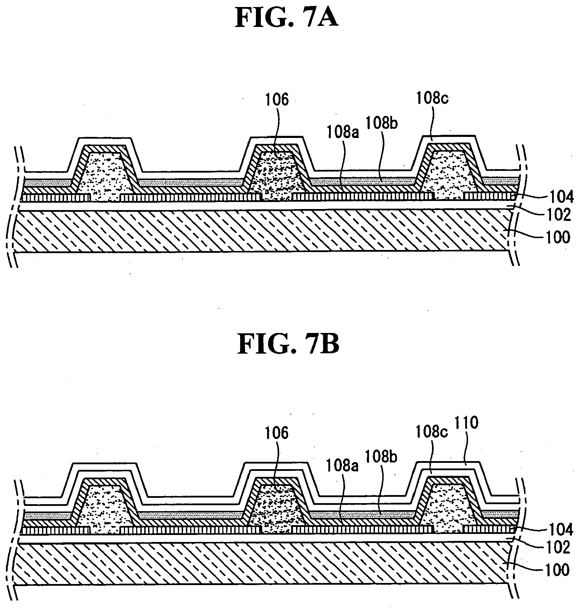

With reference to FIG. 7a, an electron transport layer (ETL) material and an electron injection layer (EIL) material are successively deposited on the entire surface of the acceptor substrate 100 with the light emission layer 108b formed thereon, through a thermal evaporation process using the existing boat or the like to form an electron relevant layer 108c. The hole relevant layer 108a, the light emission layer 108b, and the electron relevant layer 108c constitute an organic compound layer of the OLED. With reference to FIG. 7b, the second electrode 110 of the OLED is formed on the entire surface of the acceptor substrate 100 with the electron relevant layer 108c formed thereon. The second electrode 110, a cathode electrode, may be formed with a single-layer structure made of a metal material or may be formed with a multi-layered structure including one or two metal layers interposed between dielectric layers. The second electrode 110 applies electrons, applied via the Vss supply wiring, to the organic compound layer.

As described above, according to the method of fabricating an OLED display device according to exemplary embodiments of the present invention, the donor substrate with the metal pattern and the organic light emission material layer formed thereon is aligned and attached to the acceptor substrate with the TFT array formed thereon under a vacuum or inert gas atmosphere, an instantaneous voltage/current is applied to the metal pattern of the donor substrate to generate Joule heat, and the organic light emission material layer formed on the donor substrate is then sublimated by using the Joule heat, thus forming the light emission layer on the acceptor substrate.

Accordingly, compared with the existing boat method using a metal mask, in the present invention, the light emission layer can be precisely patterned to support a large area and high definition, a process TACT can be reduced in forming the light emission layer, and the size of a chamber for forming the light emission layer can be considerably reduced.

It will be apparent to those skilled in the art that various modifications and variations can be made in the present invention. For example, in the exemplary embodiments of the present invention, the first and second electrodes are anode and cathode electrodes, respectively, but the present invention is not limited thereto and can be applicable as it is to the case where first and second electrodes are cathode and anode electrodes, respectively. In this case, the hole relevant layer as described in the exemplary embodiments of the present invention may be replaced by an electron relevant layer, and the electron relevant layer as described in the exemplary embodiments of the present invention may be replaced by a hole relevant layer. The present invention is defined by the appended claims.

## Claims

1. A method of fabricating an organic light emitting diode display device, comprising the steps of:
- sequentially forming a thin film transistor array (102), a first electrode (104), a bank pattern (106), spacers (112), and a hole relevant layer (108a) on an acceptor substrate (100), wherein the first electrode (104) is formed on the thin film transistor array (102), the bank pattern (106) is formed on the thin film transistor array (102) and the first electrode (104), the spacers (112) are formed on the bank pattern (106), and the hole relevant layer (108a) is formed on the first electrode (104), the bank pattern (106) and the spacers (112);
- sequentially forming a metal pattern (202) and an organic light emission material layer (EML) on a donor substrate (200);
- aligning the donor substrate (200) over the acceptor substrate (100);
- forming a light emission layer (108b) by transferring the organic light emission material layer (EML) from the donor substrate (200) to a corresponding region of the acceptor substrate (100) in one step; and
- sequentially forming an electron relevant layer (108c) and a second electrode (110) over the light emission layer (108b) on the acceptor substrate (100), wherein the electron relevant layer (108c) is formed on the light emission layer (108b) and the hole relevant layer (108a), and the second electrode (110) is formed on the electron relevant layer (108c);
wherein the step of transferring the organic light emission material layer (EML) comprises supplying the donor substrate (200) with a power voltage to sublimate the organic light emission material layer (EML),
wherein the metal pattern (202) is patterned according to a pixel position of the acceptor substrate (100) where the light emission layer (108b) is to be formed,
wherein the spacers (112) are formed to be narrower than the bank pattern (106) to reduce a contact area between the acceptor substrate (100) and the donor substrate (200) in forming the light emission layer (108b), and
wherein the donor substrate (200) is attached to the acceptor substrate (100) during the step of forming the light emission layer (108b) such that the spacers (112) contact the organic light emission material layer (EML) between the metal pattern (202).

2. The method of claim 1, wherein the metal pattern (202) is made of one or an alloy of two or more of Ag, Au, Al, Cu, Mo, Pt, Ti, W, and Ta.

3. The method of claim 1, wherein the step of transferring the organic light emission material layer (EML) is performed under a vacuum or an inert gas atmosphere.

4. The method of claim 1, wherein the power voltage is applied one or several times with a power density of 0.1 W/cm² ~ 10000 W/cm² within a range of 0.1 µs to 1s.

5. The method of claim 1, further comprising:
- forming an electric insulation layer (204) on the metal pattern (202) before the organic light emission material layer (EML) is formed.

6. The method of claim 5, wherein the electric insulation layer (204) comprises at least one of a silicon oxide film, a silicon nitride film, a silicon oxynitride film, and a spin-on-glass (SOG) material.

7. The method of claim 1, wherein the step of forming the light emission layer (108b) includes performing the following processes respectively:
- for all of R pixels, aligning and attaching the acceptor substrate (100) and the donor substrate (200), transferring a red organic light emission material layer onto the acceptor substrate (100), detaching and unloading the donor substrate (200), one time;
- for all of G pixels, aligning and attaching the acceptor substrate (100) and the donor substrate (200), transferring a green organic light emission material layer onto the acceptor substrate (100), detaching and unloading the donor substrate (200), one time; and
- for all of B pixels, aligning and attaching the acceptor substrate (100) and the donor substrate (200), transferring a blue organic light emission material layer onto the acceptor substrate (100), detaching and unloading the donor substrate (200), one time.

8. The method of claim 1, wherein the spacers (112) are formed as one of a line type, a column type, and a well type.

## Patentansprüche

1. Verfahren zum Herstellen einer Anzeigevorrichtung organischer lichtaussendender Dioden, das die Schritte umfasst:
- sequenzielles Bilden einer Anordnung von Dünnschichttransistoren (102), einer ersten Elektrode (104), eines Bankmusters (106), von Abstandshaltern (112) und einer lochrelevanten Schicht (108a) auf einem Akzeptorsubstrat (100), wobei die erste Elektrode (104) auf der Anordnung von Dünnschichttransistoren (102) gebildet wird, das Bankmuster (106) auf der Anordnung von Dünnschichttransistoren (102) und der ersten Elektrode (104) gebildet wird, die Abstandshalter (112) auf dem Bankmuster (106) gebildet werden und die lochrelevante Schicht (108a) auf der ersten Elektrode (104), dem Bankmuster (106) und den Abstandshaltern (112) gebildet wird;
- sequenzielles Bilden eines Metallmusters (202) und einer Schicht eines organischen Lichtaussendungsmaterials (EML) auf einem Donatorsubstrat (200);
- Ausrichten des Donatorsubstrats (200) über dem Akzeptorsubstrat (100);
- Bilden einer Lichtaussendungsschicht (108b) durch Übertragen der Schicht des organischen Lichtaussendungsmaterials (EML) von dem Donatorsubstrat (200) zu einem entsprechenden Bereich des Akzeptorsubstrats (100) in einem Schritt; und
- sequenzielles Bilden einer elektronrelevanten Schicht (108c) und einer zweiten Elektrode (110) über der Lichtaussendungsschicht (108b) auf dem Akzeptorsubstrat (100), wobei die elektronrelevante Schicht (108c) auf der Lichtaussendungsschicht (108b) und der lochrelevanten Schicht (108a) gebildet wird und die zweite Elektrode (110) auf der elektronrelevanten Schicht (108c) gebildet wird;
wobei der Schritt des Übertragens der Schicht des organischen Lichtaussendungsmaterials (EML) umfasst, das Donatorsubstrat (200) mit einer Leistungsspannung zu versorgen, um die Schicht eines organischen Lichtaussendungsmaterials (EML) zu sublimieren,
wobei das Metallmuster (202) gemäß einer Pixelposition des Akzeptorsubstrats (100) gemustert wird, wo die Lichtaussendungsschicht (108b) zu bilden ist,
wobei die Abstandshalter (112) so geformt sind, dass sie schmaler als das Bankmuster (106) sind, um einen Kontaktbereich zwischen dem Akzeptorsubstrat (100) und dem Donatorsubstrat (200) beim Bilden der Lichtaussendungsschicht (108b) zu verringern, und
wobei das Donatorsubstrat (200) an dem Akzeptorsubstrat (100) während des Schrittes des Bildens der Lichtaussendungsschicht (108b) derart angebracht wird, dass die Abstandshalter (112) die Schicht eines organischen Lichtaussendungsmaterials (EML) zwischen dem Metallmuster (202) kontaktieren.

2. Verfahren nach Anspruch 1, wobei das Metallmuster (202) aus einem oder einer Legierung von zwei oder mehreren von Ag, Au, Al, Cu, Mo, Pt, Ti, W und Ta hergestellt ist.

3. Verfahren nach Anspruch 1, wobei der Schritt des Übertragens der Schicht des organischen Lichtaussendungsmaterials (EML) unter einem Unterdruck oder einer Atmosphäre eines inerten Gases ausgeführt wird.

4. Verfahren nach Anspruch 1, wobei die Leistungsspannung ein oder mehrere Male mit einer Leistungsdichte von 0,1 W/cm² ~ 10000 W/cm² innerhalb eines Bereichs von 0,1 µs bis 1 s angewendet wird.

5. Verfahren nach Anspruch 1, das ferner umfasst:
- Bilden einer elektrischen Isolationsschicht (204) auf dem Metallmuster (202) bevor die Schicht eines organischen Lichtaussendungsmaterials (EML) gebildet wird.

6. Verfahren nach Anspruch 5, wobei die elektrische Isolationsschicht (204) mindestens eine von einer Siliziumoxidschicht, einer Siliziumnitridschicht, einer Siliziumoxynitridschicht und einem Aufspinnglas (SOG) umfasst.

7. Verfahren nach Anspruch 1, wobei der Schritt des Bildens der Lichtaussendungsschicht (108b) enthält, jeweils die folgenden Prozesse auszuführen:
- für alle R-Pixel einmaliges Ausrichten und Anbringen des Akzeptorsubstrats (100) und des Donatorsubstrats (200), Übertragen einer Schicht eines roten organischen Lichtaussendungsmaterials auf das Akzeptorsubstrat (100), Lösen und Ausladen des Donatorsubstrats (200);
- für alle G-Pixel einmaliges Ausrichten und Anbringen des Akzeptorsubstrats (100) und des Donatorsubstrats (200), Übertragen einer Schicht eines grünen organischen Lichtaussendungsmaterials auf das Akzeptorsubstrat (100), Lösen und Ausladen des Donatorsubstrats (200); und
- für alle B-Pixel einmaliges Ausrichten und Anbringen des Akzeptorsubstrats (100) und des Donatorsubstrats (200), Übertragen der Schicht des blauen organischen Lichtaussendungsmaterials auf das Akzeptorsubstrat (100), Lösen und Ausladen des Donatorsubstrats (200).

8. Verfahren nach Anspruch 1, wobei die Abstandshalter (112) als einer eines Reihentyps, eines Säulentyps und eines Schachttyps gebildet sind.

## Revendications

1. Procédé de fabrication d'un dispositif d'affichage à diodes électroluminescentes organiques, comprenant les étapes de :
- la formation séquentielle d'un réseau de transistors à film mince (102), d'une première électrode (104), d'un motif de rangée (106), d'entretoises (112), et d'une couche conforme de trous (108a) sur un substrat accepteur (100), dans lequel la première électrode (104) est formée sur le réseau de transistors à film mince (102), le motif de rangée (106) est formé sur le réseau de transistors à film mince (102) et la première électrode (104), les entretoises (112) sont formées sur le motif de rangée (106), et la couche conforme de trous (108a) est formée sur la première électrode (104), le motif de rangée (106) et les entretoises (112) ;
- la formation séquentielle d'un motif de métal (202) et d'une couche de matériau électroluminescent organique (EML) sur un substrat donneur (200) ;
- l'alignement du substrat donneur (200) sur le substrat accepteur (100) ;
- la formation d'une couche électroluminescente (108b) par le transfert de la couche de matériau électroluminescent organique (EML) du substrat donneur (200) à une région correspondante du substrat accepteur (100) en une étape ; et
- la formation séquentielle d'une couche conforme d'électrons (108c) et d'une deuxième électrode (110) sur la couche électroluminescente (108b) sur le substrat accepteur (100), dans lequel la couche conforme d'électrons (108c) est formée sur la couche électroluminescente (108b) et la couche conforme de trous (108a), et la deuxième électrode (110) est formée sur la couche conforme d'électrons (108c) ;
dans lequel l'étape du transfert de la couche de matériau électroluminescent organique (EML) comprend la fourniture au substrat donneur (200) d'une tension électrique pour sublimer la couche de matériau électroluminescent organique (EML),
dans lequel le motif de métal (202) est structuré en fonction d'une position de pixels du substrat accepteur (100) où la couche électroluminescente (108b) doit être formée,
dans lequel les entretoises (112) sont formées pour être plus étroites que le motif de rangée (106) pour réduire une superficie de contact entre le substrat accepteur (100) et le substrat donneur (200) dans la formation de la couche électroluminescente (108b), et
dans lequel le substrat donneur (200) est attaché au substrat accepteur (100) au cours de l'étape de la formation de la couche électroluminescente (108b) de sorte que les entretoises (112) soit en contact avec la couche de matériau électroluminescent organique (EML) entre le motif de métal (202).

2. Procédé selon la revendication 1, dans lequel le motif de métal (202) est constitué d'un ou d'un alliage d'au moins deux de Ag, Au, Al, Cu, Mo, Pt, Ti, W et Ta.

3. Procédé selon la revendication 1, dans lequel l'étape du transfert de la couche de matériau électroluminescent organique (EML) est effectuée sous vide ou dans une atmosphère de gaz inerte.

4. Procédé selon la revendication 1, dans lequel la tension électrique est appliquée une ou plusieurs fois avec une densité électrique de 0,1 W/cm² ~ 10 000 W/cm² à l'intérieur d'une plage de 0,1 µs à 1 s.

5. Procédé selon la revendication 1, comprenant en outre :
- la formation d'une couche d'isolation électrique (204) sur le motif de métal (202) avant la formation de la couche de matériau électroluminescent organique (EML).

6. Procédé selon la revendication 5,
dans lequel la couche d'isolation électrique (204) comprend au moins l'un d'un film d'oxyde de silicium, d'un film de nitrure de silicium, d'un film d'oxynitrure de silicium et d'un matériau de verre déposé par centrifugation (SOG).

7. Procédé selon la revendication 1, dans lequel l'étape de la formation de la couche électroluminescente (108b) comprend l'exécution respectivement des processus suivants :
- pour l'intégralité des pixels rouges (R), l'alignement et l'attachement du substrat accepteur (100) et du substrat donneur (200), le transfert d'une couche de matériau électroluminescent organique rouge sur le substrat accepteur (100), le détachement et le déchargement du substrat donneur (200) une fois ;
- pour l'intégralité des pixels verts (G), l'alignement et l'attachement du substrat accepteur (100) et du substrat donneur (200), le transfert d'une couche de matériau électroluminescent organique vert sur le substrat accepteur (100), le détachement et le déchargement du substrat donneur (200) une fois ; et
- pour l'intégralité des pixels bleus (B), l'alignement et l'attachement du substrat accepteur (100) et du substrat donneur (200), le transfert d'une couche de matériau électroluminescent organique bleu sur le substrat accepteur (100), le détachement et le déchargement du substrat donneur (200) une fois.

8. Procédé selon la revendication 1, dans lequel les entretoises (112) sont formées en tant que l'un d'un type de ligne, d'un type de colonne et d'un type de puits.
